# EUROPÄISCHE PATENTSCHRIFT

(11) **EP 3 718 136 B1**
(45) Veröffentlichungstag und Bekanntmachung des Hinweises auf die Patenterteilung: **17.08.2022**
(21) Anmeldenummer: 19716805.7
(22) Anmeldetag: 26.03.2019
(51) Int. Cl.: H01L 23/498

(54) **HALBLEITERBAUGRUPPE UND VERFAHREN ZUR HERSTELLUNG DER HALBLEITERBAUGRUPPE**
SEMICONDUCTOR MODULE AND METHOD OF MANUFACTURING SAME
ENSEMBLE SEMI-CONDUCTEUR ET PROCÉDÉ DE FABRICATION DE L'ENSEMBLE SEMI-CONDUCTEUR

(30) Priorität: 29.03.2018 EP 18165112
(43) Veröffentlichungstag der Anmeldung: 07.10.2020
(73) Patentinhaber: Siemens Aktiengesellschaft, 80333 München (DE)
(72) Erfinder: OCHS, Ewgenij, 90765 Fürth (DE); PFEFFERLEIN, Stefan, 90562 Heroldsberg (DE)
(86) Internationale Anmeldenummer: PCT/EP2019/057570
(87) Internationale Veröffentlichungsnummer: WO 2019/185620

(56) Entgegenhaltungen:
- EP-A2- 2 312 916
- US-A1- 2007 111 397
- US-A1- 2008 305 582
- US-A1- 2013 075 932
- US-A1- 2013 273 694
- US-A1- 2017 301 606

## Beschreibung

Die Erfindung betrifft eine Halbleiterbaugruppe, welche ein Trägerelement mit einer ersten Trägerelement-Leiterbahn, einen Halbleiter und ein elektrisch isolierendes Element mit einer ersten Isolationselement-Leiterbahn aufweist. Ferner betrifft die Erfindung ein Verfahren zur Herstellung der Halbleiterbaugruppe und ein Halbleiterbaugruppensystem mit mindestens zwei der Halbleiterbaugruppen.

US 2013/075932 offenbart ein Leistungshalbleitermodul mit einem Halbleiterchip, der zwischen zwei Leiterplatten angeordnet ist.

Halbleiter von Halbleiterbaugruppen, wie sie beispielsweise im industriellen Umfeld als Leistungshalbleiter oder Leistungshalbleitermodule in Baugruppen von elektrischen Antriebs- oder Automatisierungsgeräten zum Einsatz kommen, werden mit Trägerelementen, meist in Form von Leiterplatten, über die darauf angeordneten Trägerelemente-Leiterbahnen sowohl mechanisch wie auch elektrisch mit der internen Peripherie der genannten Geräte verbunden. Die Halbleiter weisen dabei meist nicht nur an einer ihrer Seiten mechanische und elektrische Verbindungen mit dem Trägerelement auf. Insbesondere bei derartigen Leistungshalbleitermodulen werden die Anschlüsse dieser Halbleiter oft über zwei sich gegenseitig abgewandten Seiten des Halbleiters kontaktiert, wobei ein Teil der Anschlüsse an einer der Seiten des Halbleiters elektrisch und mechanisch oftmals auch über die auf einem elektrisch isolierenden Element, welches meist als Substrat aus Keramik ausgebildet ist, angeordnete Isolationselement-Leiterbahnen kontaktiert werden.

Ferner ist das elektrisch isolierende Element im Allgemeinen auch mit einem Kühlkörper verbunden, welcher im Betrieb der Halbleiter deren Wärmeverluste aufnimmt und an die weitere Umgebung abführt.

Bei der Herstellung derartiger elektrischer und mechanischer Verbindungen werden oft SMD-Lötverfahren für eine stoffschlüssige mechanische Verbindungen angewandt, wobei die Erwärmung und der anschließende Abkühlungsvorgang des Verbindungsmaterials, hier beispielsweise des Lotmaterials, zur Folge hat, dass sich beispielsweise das elektrisch isolierende Element mit dem Halbleiter in Bezug auf das Trägerelement nicht wie vorgesehen parallel über die sich gegenüberliegenden Flächen von elektrisch isolierendem Element und Trägerelement anordnen, sondern verkippen oder sich sogar in ihrer eigenen Struktur verziehen.

Dies geschieht u.a. dadurch, dass beim Aufschmelzen des Lotmaterials durch Ausgasung von dessen Binde- und Flussmittel ein für hohe Qualitätsanforderungen nur unzureichend einschätzbarer Volumenschwund des Lotmaterials am Lotdepot auftritt. Ferner resultiert durch eine sich am Lotmaterial bildende Benetzungskraft sowie durch die Abkühlung und Schrumpfung des Lotmaterials eine anziehende Wirkung der mechanisch und elektrisch zu verbindenden Bauelemente.

Eine Möglichkeit, die mechanisch und elektrisch zu verbindenden Bauelemente, wie Halbleiter, Trägerelement und elektrisch isolierendes Element, auch nach dem thermischen Verbindungsprozess, hier beispielsweise nach dem SMD-Lötprozess, in ihrer gegenüberliegenden Anordnung parallel zu halten und nicht zu verkippen, können entsprechende Fixierwerkzeuge oder auch Fixierkleber zur Fixierung der beispielsweise zu lötenden Bauelement bieten.

Diese bekannten Lösungen stellen jedoch an den Herstellungsprozess von Halbleiterbaugruppen sehr hohe Anforderungen bzgl. der Erreichung der geforderten Qualität mit den aufgezeigten Mitteln, welche unter Berücksichtigung von immer eingeschränkteren Kostenstrukturen der Hersteller nur noch schwer erreichbar ist.

Ferner besteht die Gefahr, dass bei einer betriebsbedingten, insbesondere übermäßigen Erwärmung der Halbleiterbaugruppe eine erneute thermische Beanspruchung der durch den Lötprozess am Lotdepot entstandenen Verbindungen erfolgt, so dass das beschriebene Verkippen in Ermanglung einer ausreichenden Fixierung der genannten Bauelemente nunmehr erstmals auftreten kann.

Der Erfindung liegt daher die Aufgabe zugrunde, eine Halbleiterbaugruppe und ein Verfahren zur Herstellung der Halbleiterbaugruppe vorzuschlagen, welche ein Verkippen von Bauelementen der Halbleiterbaugruppe nach einer thermischen Behandlung von Verbindungsmaterialien zur Erzeugung mechanischer Verbindungen, welche auch elektrische Verbindungen bereitstellen, innerhalb der Halbleiterbaugruppe verhindern oder gegenüber dem Stand der Technik verbessern.

Die Aufgabe wird durch eine Halbleiterbaugruppe mit den in Anspruch 1 angegebenen Merkmalen gelöst. Ferner wird die Aufgabe durch ein Verfahren zur Herstellung der Halbleiterbaugruppe nach Anspruch 12 und ein Halbleiterbaugruppensystem nach Anspruch 13 gelöst.

Vorteilhafte Ausgestaltungsformen der Halbleiterbaugruppe sind in den abhängigen Ansprüchen angegeben.

Der Erfindung liegt unter anderem die Erkenntnis zugrunde, dass gegenüber dem Stand der Technik Fixier- bzw. Abstandselemente benötigt werden, welche in den Herstellungsprozess von Halbleiterbaugruppen aufwandsarm einbringbar sind, unbeeinflussbar von thermischer Behandlungen der Verbindungsmaterialien zur Erzeugung von mechanischen wie mechanisch/elektrischen Verbindungen sind und im Betrieb dauerhaft die beschriebene Verkippung von Bauelementen bei z.T. auch kurzzeitigen Erwärmungen über einen Wert für die Erwärmung der Halbleiterbaugruppe bei Dauerbetrieb hinaus (z.B. kurzzeitige Spitzenlast) verhindern.

Für die Lösung der Aufgabe wird eine Halbleiterbaugruppe vorgeschlagen, welche ein Trägerelement mit einer ersten Trägerelement-Leiterbahn, einen Halbleiter, ein elektrisch isolierendes Element, aufweisend eine erste Isolationselement-Leiterbahn, ein erstes Abstandselement und mindestens ein weiteres Abstandselement umfasst, wobei der Halbleiter an einer ersten Halbleiterseite mittels eines ersten Verbindungsmaterials mit der ersten Trägerelement-Leiterbahn elektrisch und mechanisch verbunden ist, wobei der Halbleiter an einer zweiten Halbleiterseite, welche von der ersten Halbleiterseite des Halbleiters abgewandt ist, mittels eines zweiten Verbindungsmaterials mit der ersten Isolationselement-Leiterbahn, welche an einer ersten Isolationselementseite des elektrisch isolierenden Elements angeordnet ist, elektrisch und mechanisch verbunden ist, wobei das erste Abstandselement zum Halten eines Abstands zwischen dem Trägerelement und einem der zweiten Halbleiterseite des Halbleiters zugewandten Baugruppenelement angeordnet und jeweils mit dem Trägerelement und dem Baugruppenelement mechanisch verbunden ist, wobei das weitere Abstandselement ebenfalls zum Halten des Abstands zwischen dem Trägerelement und dem der zweiten Halbleiterseite des Halbleiters zugewandten Baugruppenelement angeordnet und mechanisch mit dem Trägerelement und dem Baugruppenelement verbunden ist, wobei das erste Abstandselement und zumindest das eine weitere Abstandselement als ein gemeinsames Abstandselement ausbildet ist und wobei das gemeinsame Abstandselement aus zumindest zwei Segmenten besteht und einen geschlossenen oder zumindest annähernd geschlossenen Rahmen bildet.

Das erste Abstandselement verhindert auf vorteilhafte Weise ein Verkippen des Baugruppenelements und beispielsweise daran mechanisch befestigter weiterer Bauelemente gegenüber dem Trägerelement, indem das erste Abstandselement den Abstand zwischen Baugruppenelement und Trägerelement definiert und unabhängig von thermischen Belastungen während der Herstellung und im Betrieb der Halbleiterbaugruppe, welche auch über die thermische Behandlung der Verbindungsmaterialien zur Herstellung von elektrischen und mechanischen Verbindung hinausgehen kann, das Baugruppenelement zumindest in Bezug auf das Trägerelement fixiert und auf Abstand hält.

Die erfindungsgemäße Halbleiterbaugruppe unterstützt ferner eine Kontaktierung des Halbleiters von zwei jeweils gegeneinander abgewandten Seiten des Halbleiters zum Einen über die erste Trägerelement-Leiterbahn des Trägerelements zum Anderen über die erste Isolationselement-Leiterbahn des elektrisch isolierenden Elements. Das elektrisch isolierende Element kann dabei zumindest zum Teil auch als entwärmendes Bauelement (als Kühlkörper) für eine betriebliche Entwärmung des Halbleiters vorgesehen sein.

Der durch das gemeinsame Abstandselement gebildete Rahmen kann beispielsweise den Halbleiter vorteilhaft umschließen.

Ein annähernd geschlossener Rahmen weist zumindest eine Öffnung im Rahmen auf, mittels der beispielsweise eine elektrische Verbindung von außerhalb des Rahmens in den vom Rahmen umschlossenen Innenraum einführbar ist oder eine Vergussmasse von außerhalb des Rahmens in den vom Rahmen umschlossenen Innenraum einbringbar ist.

Jedoch ist auch denkbar, dass das erste Abstandselement für sich allein einen geschlossenen oder einen zumindest annähernd geschlossenen Rahmen bildet.

Bei einer alternativen, nicht von dieser Erfindung umfassten Ausführungsform, umfasst eine Halbleiterbaugruppe ein Trägerelement mit einer ersten Trägerelement-Leiterbahn, einen Halbleiter, ein elektrisch isolierendes Element, aufweisend eine erste Isolationselement-Leiterbahn, und ein erstes Abstandselement, wobei der Halbleiter an einer ersten Halbleiterseite mittels eines ersten Verbindungsmaterials mit der ersten Trägerelement-Leiterbahn elektrisch und mechanisch verbunden ist, wobei der Halbleiter an einer zweiten Halbleiterseite, welche von der ersten Halbleiterseite des Halbleiters abgewandt ist, mittels eines zweiten Verbindungsmaterials mit der ersten Isolationselement-Leiterbahn, welche an einer ersten Isolationselementseite des elektrisch isolierenden Elements angeordnet ist, elektrisch und mechanisch verbunden ist, wobei das erste Abstandselement zum Halten eines Abstands zwischen dem Trägerelement und einem der zweiten Halbleiterseite des Halbleiters zugewandten Baugruppenelement angeordnet und jeweils mit dem Trägerelement und dem Baugruppenelement mechanisch verbunden ist.

Bei einer ersten vorteilhaften Ausgestaltungsform der Halbleiterbaugruppe umfasst die Halbleiterbaugruppe mindestens ein weiteres Abstandselement, wobei das weitere Abstandselement zum Halten des Abstands zwischen dem Trägerelement und dem der zweiten Halbleiterseite des Halbleiters zugewandten Baugruppenelement angeordnet und mechanisch mit dem Trägerelement und dem Baugruppenelement verbunden ist.

Ein weiteres Abstandselement verbessert hier in vorteilhafter Weise die Stabilität der Fixierung und der Haltung des Abstandes zwischen dem Trägerelement und dem Baugruppenelement und erhöht somit die Verkippungssicherheit durch z.B. eine geometrische Anordnung der entsprechenden Abstandselemente je nach Bedarf, wobei der Bedarf sich dann z.B. aus der geometrischen Aufbaustruktur der Halbleiterbaugruppe ableitet.

Bei einer weiteren vorteilhaften Ausgestaltungsform der Halbleiterbaugruppe sind das erste Abstandselement und, falls vorhanden, das weitere Abstandselement im betriebsführenden Zustand der Halbleiterbaugruppe zumindest elektrisch stromlos oder elektrisch spannungsfrei und elektrisch stromlos.

Der Vorteil dieser Ausgestaltungsform besteht z.B. darin, dass die Abstandselemente nicht nur aus elektrisch leitenden Materialien bestehen müssen. Auch mechanisch stabile und im Wesentlichen nichtleitbare Materialien, wie Kunststoffe und Keramiken, können demnach für die Ausbildung der Abstandselemente eingesetzt werden.

Bei einer weiteren vorteilhaften Ausgestaltungsform der Halbleiterbaugruppe sind das erste Abstandselement und, falls vorhanden, das weitere Abstandselement jeweils einteilig oder mehrteilig, insbesondere schichtartig, ausgebildet.

Durch die mehrteilige, insbesondere mehrschichtige Ausbildung der Abstandselemente wird mittels der Abstandselemente eine feingranulare, anforderungsbezogene Einstellung zum Halten des Abstandes zwischen dem Trägerelement und dem Baugruppenelement erzeugt.

Bei einer weiteren vorteilhaften Ausgestaltungsform der Halbleiterbaugruppe ist das Baugruppenelement das elektrisch isolierende Element oder ist das Baugruppenelement ein Wärmeleitelement, welches an einer von der ersten Isolationselementseite abgewandten zweiten Isolationselementseite des elektrisch isolierenden Elements angeordnet und mit dem elektrisch isolierenden Element mechanisch verbunden ist oder ist das Baugruppenelement ein Kühlkörper, welcher an einer von der ersten Isolationselementseite abgewandten zweiten Isolationselementseite des elektrisch isolierenden Elements angeordnet und mit dem elektrisch isolierenden Element unmittelbar oder über ein Wärmeleitelement mechanisch verbunden ist.

Je nach strukturellem Aufbau der Halbleiterbaugruppe und deren räumlichen Möglichkeiten können in vorteilhafter Weise das erste Abstandselement und, falls vorhanden, das weitere Abstandselement zwischen dem Trägerelement und verschiedenen hier als Baugruppenelement benannten Elementen, dem elektrisch isolierenden Element, dem Wärmeleitelement und dem Kühlkörper, zum Halten des Abstandes und zum Fixieren angeordnet werden. Damit ist ein flexibler Aufbau der Halbleiterbaugruppe je nach Kundenanforderung und technischer Weiterentwicklung möglich.

Das Wärmeleitelement (z.B. ausgebildet als Wärmeleitpad oder Wärmeleitpaste aufweisend) wird oftmals zur besseren Entwärmung des Halbleiters unmittelbar zwischen das elektrisch isolierende Element (z.B. ein Keramiksubstrat an welchem der Halbleiter kontaktiert ist) und dem Kühlkörper (meist das hauptsächliche Entwärmungselement der Halbleiterbaugruppe) eingebracht.

Bei einer weiteren vorteilhaften Ausgestaltungsform der Halbleiterbaugruppe, dann wenn das Baugruppenelement das elektrisch isolierende Element ist, weisen das erste Abstandselement und, falls vorhanden, das weitere Abstandselement jeweils eine erste Höhe auf, deren Höhenwert maximal den Abstandswert eines ersten Abstands zwischen dem elektrisch isolierenden Element und dem Trägerelement im unmittelbaren Bereich der mechanischen Verbindung des jeweiligen Abstandselements mit dem elektrisch isolierenden Element und dem Trägerelement annehmen kann.

Mit dieser vorteilhaften Ausgestaltungsform wird die erste Höhe der Abstandselemente derart begrenzt, dass einerseits der notwendige erste Abstand zwischen Trägerelement und elektrisch isolierende Element gehalten wird, um das Trägerelement und das elektrisch isolierende Element gegeneinander ausreichend zu fixieren, und andererseits darauf geachtet wird, dass der Raum (z.B. für Lotdepot) für das Verbindungsmaterial (z.B. das Lot) für die Herstellung von mechanischen und elektrischen Verbindungen je nach thermischen Behandlungsverfahren (z.B. durch Löten) für eine qualitativ hochwertige Verbindung (z.B. eine niederohmige und niederinduktive elektrische Verbindung) weder zu gering noch zu groß ist.

Bei einer weiteren vorteilhaften Ausgestaltungsform der Halbleiterbaugruppe, dann wenn das Baugruppenelement das Wärmeleitelement ist, weisen das Abstandselement und, falls vorhanden, das weitere Abstandselement jeweils eine zweite Höhe auf, deren Höhenwert maximal den Abstandswert eines zweiten Abstands zwischen dem Wärmeleitelement und dem Trägerelement im unmittelbaren Bereich der mechanischen Verbindung des jeweiligen Abstandselements mit dem Wärmeleitelement und dem Trägerelement annehmen kann.

Mit dieser vorteilhaften Ausgestaltungsform wird die zweite Höhe der Abstandselemente derart begrenzt, dass einerseits der notwendige zweite Abstand zwischen Trägerelement und Wärmeleitelement gehalten wird, um das Trägerelement und das Wärmeleitelement gegeneinander ausreichend zu fixieren, und andererseits darauf geachtet wird, dass der Raum (z.B. das Lotdepot) für das Verbindungsmaterial (z.B. das Lot) für die Herstellung von mechanischen und elektrischen Verbindungen je nach thermischen Behandlungsverfahren (z.B. durch Löten) für eine qualitativ hochwertige Verbindung (z.B. eine niederohmige und niederinduktive elektrische Verbindung) weder zu gering noch zu groß ist.

Bei einer weiteren vorteilhaften Ausgestaltungsform der Halbleiterbaugruppe, dann wenn das Baugruppenelement der Kühlkörper ist, weisen das Abstandselement und, falls vorhanden, das weitere Abstandselement jeweils eine dritte Höhe auf, deren Höhenwert maximal den Abstandswert eines dritten Abstands zwischen dem Kühlkörper und dem Trägerelement im unmittelbaren Bereich der mechanischen Verbindung des jeweiligen Abstandselements mit dem Kühlkörper und dem Trägerelement annehmen kann.

Mit dieser vorteilhaften Ausgestaltungsform wird die erste Höhe der Abstandselemente derart begrenzt, dass einerseits der notwendige erste Abstand zwischen Trägerelement und Kühlkörper gehalten wird, um das Trägerelement und den Kühlkörper gegeneinander ausreichend zu fixieren, und andererseits darauf geachtet wird, dass der Raum (z.B. das Lotdepot) für das Verbindungsmaterial (z.B. das Lot) für die Herstellung von mechanischen und elektrischen Verbindungen je nach thermischen Behandlungsverfahren (z.B. durch Löten) für eine qualitativ hochwertige Verbindung (z.B. eine niederohmige und niederinduktive elektrische Verbindung) weder zu gering noch zu groß ist.

Bei einer weiteren vorteilhaften Ausgestaltungsform der Halbleiterbaugruppe sind an einer oder an beiden der sich gegenüberliegenden Seiten des Trägerelements und des Baugruppenelements Ausbuchtungen vorgesehen, welche den jeweils ersten Abstand oder den jeweils zweiten Abstand oder den jeweils dritten Abstand an der Stelle zwischen dem Trägerelement und dem Baugruppenelement reduzieren, an dem das erste Abstandselement und, falls vorhanden, das weitere Abstandselement angeordnet sind.

Diese Ausbuchtungen des Baugruppenelements und/oder des Trägerelements können vorteilhaft als eine monolithisch Einheit mit dem Baugruppenelement und/oder dem Trägerelement ausbildet sein oder z.B. formschlüssig oder kraftschlüssig mit dem Baugruppenelement und/oder dem Trägerelement mechanisch verbunden sein. Möglich ist auch, dass diese Ausbuchtungen teilweise oder vollständig Abstandshalter ausbilden.

Bei einer weiteren vorteilhaften Ausgestaltungsform der Halbleiterbaugruppe ist die erste Isolationselement-Leiterbahn mittels eines vierten Verbindungsmaterials mit einer zweiten Trägerelement-Leiterbahn elektrisch und mechanisch verbunden.

Mittels dieser mechanischen Verbindung wird in vorteilhafter Weise eine erste elektrische Kontaktierung von Kontakten, welche auf der zweiten Halbleiterseite des Halbleiters angeordnet sind und elektrischen Bauelementen, welche auf dem Trägerelement angeordnet sind bzw. über das Trägerelement erreichbar sind, erzeugt, wobei das Trägerelement von der zweiten Halbleiterseite des Halbleiters abgewandt ist.

Bei einer weiteren vorteilhaften Ausgestaltungsform der Halbleiterbaugruppe ist der Halbleiter an der zweiten Halbleiterseite mittels eines dritten Verbindungsmaterials mit einer zweiten Isolationselement-Leiterbahn, welche an der ersten Isolationselementseite des elektrisch isolierenden Elements angeordnet ist, elektrisch und mechanisch verbunden und ist die zweite Isolationselement-Leiterbahn mittels eines fünften Verbindungsmaterials mit einer dritten Trägerelement-Leiterbahn elektrisch und mechanisch verbunden.

Mittels dieser mechanischen Verbindung wird in vorteilhafter Weise eine weitere elektrische Kontaktierung von Kontakten, welche auf der zweiten Halbleiterseite des Halbleiters angeordnet sind und elektrischen Bauelementen, welche auf dem Trägerelement angeordnet sind bzw. über das Trägerelement erreichbar sind, erzeugt, wobei das Trägerelement von der zweiten Halbleiterseite Seite des Halbleiters abgewandt ist.

Bei einer weiteren vorteilhaften Ausgestaltungsform der Halbleiterbaugruppe sind der Aufschmelzpunkt des ersten Abstandselements und, falls vorhanden, der Aufschmelzpunkt des Weiteren Abstandselements höher, als der jeweilige Aufschmelzpunkt der, soweit vorhanden, Verbindungsmaterialien.

Diese vorteilhafte Ausgestaltungsform verhindert, dass die Abstandselemente während einer thermischen Behandlung (z.B. Löten) der Verbindungsmaterialien (z.B. Lotmaterial wie Lötzinn) in ihrer Struktur beschädigt oder sogar zerstört werden und so nicht mehr zum Halten des Abstandes und zum Fixieren von Trägerelement und Baugruppenelement geeignet sind. Materialien für Abstandshalter, welche eine derartige Anforderung erfüllen, können z.B. aus Metall, Keramik aber auch aus besonders hitzebeständigem Kunststoff bestehen.

Für die Lösung der Aufgabe wird weiterhin ein Verfahren zur Herstellung einer erfindungsgemäßen Halbleiterbaugruppe vorgeschlagen, welches die folgenden Verfahrensschritte aufweist.

In einem ersten Schritt erfolgt ein formschlüssiges oder kraftschlüssiges oder stoffschlüssiges Anbringen eines ersten Abstandselements und, falls vorhanden, eines weiteren Abstandselements an ein Trägerelement und/oder ein Baugruppenelement der Halbleiterbaugruppe.

In einem zweiten Schritt erfolgt ein Aufbringen eines ersten Verbindungsmaterials auf eine erste Halbleiterseite eines Halbleiters und/oder auf eine erste Trägerelement-Leiterbahn eines Trägerelements der Halbleiterbaugruppe.

In einem dritten Schritt erfolgt ein Aufbringen eines vierten Verbindungsmaterials auf eine erste Isolationselement-Leiterbahn eines elektrischen isolierenden Elements und/oder auf eine zweite Trägerelement-Leiterbahn des Trägerelements der Halbleiterbaugruppe.

In einen vierten Schritt erfolgt ein Aufbringen eines fünften Verbindungsmaterials auf eine zweite Isolationselement-Leiterbahn des elektrisch isolierenden Elements und/oder auf eine dritte Trägerelement-Leiterbahn des Trägerelements, falls eine weitere elektrische und mechanische Verbindung zwischen der zweiten Isolationselement-Leiterbahn und der dritten Trägerelement-Leiterbahn der Halbleiterbaugruppe vorgesehen ist.

In einem fünften Schritt erfolgt ein Anbringen des Trägerelements und des Baugruppenelements an das erste Abstandselement und, falls vorhanden, an das weitere Abstandselement.

In einem sechsten Schritt erfolgt eine thermische Behandlung des ersten Verbindungsmaterials, des vierten Verbindungsmaterials und, falls vorgesehen, des fünften Verbindungsmaterials zur Herstellung stoffschlüssiger elektrischer und mechanischer Verbindungen an den Trägerelement-Leiterbahnen, den Isolationselement-Leiterbahnen und dem Halbleiter.

Als thermische Behandlung kann hier beispielhaft ein Lötprozess genannt werden, welcher das Verbindungsmaterial (das Lot) derart thermisch behandelt, dass eine mechanische und elektrische Verbindung von Baugruppenelement und Trägerelement (z.B. über deren Leiterbahnen) erzeugt wird. Ferner können Verbindungsmaterialien auch mittels Sinterprozessen zur Erzeugung einer derartigen mechanischen und elektrischen Verbindung thermisch behandelt werden.

Für die Lösung der Aufgabe wird ebenfalls ein Halbleiterbaugruppensystem mit mindestens zwei erfindungsgemäßen Halbleiterbaugruppen vorgeschlagen, wobei die Kühlkörper der jeweiligen Halbleiterbaugruppen einen gemeinsamen Kühlkörper ausbilden.

Der gemeinsam ausgebildete Kühlkörper eignet sich dabei besonders vorteilhaft, den modularen Aufbau des Halbleiterbaugruppensystems sowie die mechanische Stabilität und die Entwärmung der Halbleiterbaugruppen im Halbleiterbaugruppensystem zu verbessern.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine schematische Darstellung einer Halbleiterbaugruppe nach dem Stand der Technik,
- FIG 2: eine erste schematische Darstellung der erfindungsgemäßen Halbleiterbaugruppe mit einem ersten und einem weiteren Abstandselement, welche jeweils zwischen einem Trägerelement und einem Baugruppenelement angeordnet und mechanisch mit dem Trägerelement und dem Baugruppenelement verbunden sind, wobei das Baugruppenelement als elektrisch isolierendes Element ausgebildet ist,
- FIG 3: eine zweite schematische Darstellung der erfindungsgemäßen Halbleiterbaugruppe nach FIG 1 mit einem ersten und einem weiteren Abstandselement, welche jeweils zwischen dem Trägerelement und dem Baugruppenelement angeordnet und mechanisch mit dem Trägerelement und dem Baugruppenelement verbunden sind, wobei das Baugruppenelement als Wärmeleitelement ausgebildet ist,
- FIG 4: eine dritte schematische Darstellung der erfindungsgemäßen Halbleiterbaugruppe nach FIG 1 mit einem ersten und einem weiteren Abstandselement, welche jeweils zwischen dem Trägerelement und dem Baugruppenelement angeordnet und mechanisch mit dem Trägerelement und dem Baugruppenelement verbunden sind, wobei das Baugruppenelement als Kühlkörper ausgebildet ist,
- FIG 5: eine vierte schematische Darstellung dreier erfindungsgemäßer Halbleiterbaugruppen nach FIG 1, welche gemeinsam ein Halbleiterbaugruppensystem bilden und
- FIG 6: ein Struktogramm mit einem Verfahren zur Herstellung der erfindungsgemäßen Halbleiterbaugruppe nach einer der FIGen 2 bis 4.

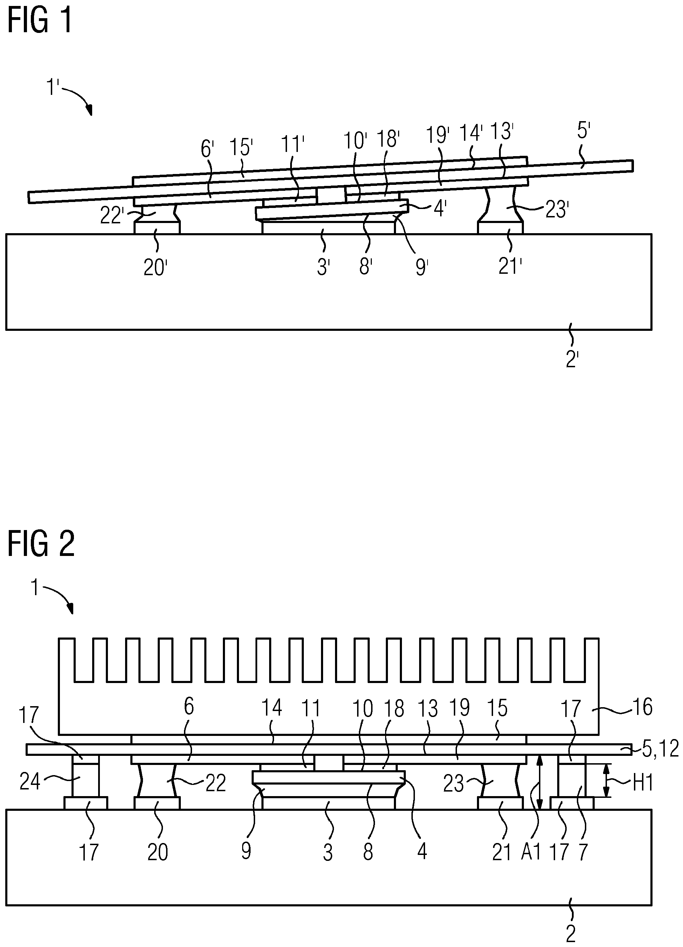

Die FIG 1 zeigt eine schematische Darstellung einer Halbleiterbaugruppe 1' nach dem Stand der Technik.

An einer ersten Trägerelement-Leiterbahn 3' eines Trägerelements 2' ist ein Halbleiter 4' mit seiner ersten Halbleiterseite 8', welche dem Trägerelement 2'zugewandt ist, über ein erstes Verbindungsmaterial 9' elektrisch und mechanisch verbunden.

Der Halbleiter 4' ist weiterhin mit seiner zweiten Halbleiterseite 10' einerseits über ein zweites Verbindungsmaterial 11' mit einer ersten Isolationselement-Leiterbahn 6' eines elektrisch isolierenden Elements 5' und andererseits über ein drittes Verbindungsmaterial 18' mit einer zweiten Isolationselement-Leiterbahn 19' des elektrisch isolierenden Elements 5' mit dem elektrisch isolierenden Element 5' an dessen erster Isolationselementseite 13' mechanisch und elektrisch verbunden.

Ferner ist die erste Isolationselement-Leiterbahn 6' über ein viertes Verbindungsmaterial 22' mit einer zweiten Trägerelement-Leiterbahn 20' des Trägerelements 2' und die zweite Isolationselement-Leiterbahn 19' über ein fünftes Verbindungsmaterial 23' mit einer dritten Trägerelement-Leiterbahn 21' des Trägerelements 2' elektrisch und mechanisch verbunden.

An der zweiten Isolationselementseite 14' des elektrisch isolierenden Elements 5' ist ein Wärmeleitelement 15' angeordnet. Dieses Wärmeleitelement 15' wird im Allgemeinen dann eingesetzt, wenn die Entwärmung des Halbleiters 4' über das elektrisch isolierende Element 5' verbessert werden soll und ein entsprechender thermischer Übergang z.B. zu einem Kühlkörper (in FIG 1 nicht gezeigt) unterstützt werden soll. Wenn ein derartiger Kühlkörper mit der zweiten Isolationselementseite 14' des elektrisch isolierenden Elements 5' verbunden ist, können auch Materialunebenheiten dieser mechanisch/thermischen Verbindung mit dem unmittelbaren Einbringen des Wärmeleitelements 15' in diese mechanisch/thermischen Verbindung ausgeglichen werden.

In der schematischen Darstellung der FIG 1 ist deutlich eine Verkippung des elektrisch isolierenden Elements 5' gegenüber dem Trägerelement 2' zu sehen, wie dies z.B. nach einem Lötvorgang beim Stand der Technik auftreten kann. In der Praxis bewegt sich der Weg der Verkippung aus der parallelen Anordnung von elektrisch isolierendem Element 5' und Trägerelement 2' heraus oftmals nur im µm-Bereich, was aber schon eine qualitativ negative Auswirkung auf den Einsatz der Halbleiterbaugruppe 1' haben kann.

Mittels der FIG 2 wird eine erste schematische Darstellung eines Ausführungsbeispiels der erfindungsgemäßen Halbleiterbaugruppe 1 mit einem ersten Abstandselement 7 und einem weiteren Abstandselement 24, welche jeweils zwischen einem Trägerelement 2 und einem Baugruppenelement 12 angeordnet und mechanisch mit dem Trägerelement 2 und dem Baugruppenelement 12 verbunden sind, aufgezeigt, wobei das Baugruppenelement 12 als elektrisch isolierendes Element 5 ausgebildet ist.

An einer ersten Trägerelement-Leiterbahn 3 des Trägerelements 2 ist ein Halbleiter 4 mit seiner ersten Halbleiterseite 8, welche dem Trägerelement 2 zugewandt ist, über ein erstes Verbindungsmaterial 9 elektrisch und mechanisch verbunden.

Der Halbleiter 4 ist weiterhin mit seiner zweiten Halbleiterseite 10 einerseits über ein zweites Verbindungsmaterial 11 mit einer ersten Isolationselement-Leiterbahn 6 des elektrisch isolierenden Elements 5 und andererseits über ein drittes Verbindungsmaterial 18 mit einer zweiten Isolationselement-Leiterbahn 19 des elektrisch isolierenden Elements 5 mit dem elektrisch isolierenden Element 5 an dessen erster Isolationselementseite 13 mechanisch und elektrisch verbunden.

Ferner ist die erste Isolationselement-Leiterbahn 6 über ein viertes Verbindungsmaterial 22 mit einer zweiten Trägerelement-Leiterbahn 20 des Trägerelements 2 und die zweite Isolationselement-Leiterbahn 19 über ein fünftes Verbindungsmaterial 23 mit einer dritten Trägerelement-Leiterbahn 21 des Trägerelements 2 elektrisch und mechanisch verbunden.

An der zweiten Isolationselementseite 14 des elektrisch isolierenden Elements 5 ist ein Wärmeleitelement 15 angeordnet. Mittels dieses Wärmeleitelements 15 ist ein Kühlkörper 16 mit dem elektrisch isolierenden Element 5 mechanisch und thermisch verbunden.

Zum Halten eines ersten Abstands A1 von dem Trägerelement 2 zu dem elektrisch isolierenden Element 5 (dem Baugruppenelement 12) und zum Fixieren derselben sind zwischen dem Trägerelement 2 und dem elektrisch isolierenden Element 5 in einem Bereich von Ausbuchtungen 17 an der ersten Isolationselementseite 13 des elektrisch isolierenden Elements 5 und des gegenüberliegen Trägerelements 2 das erste Abstandselement 7 und das weitere Abstandselement 24 angeordnet und jeweils mechanisch mit dem elektrisch isolierenden Element 5 und dem Trägerelement 2 verbunden.

Eine jeweils erste Höhe H1 der beiden Abstandselemente 7, 24 (in FIG 2 ist die erste Höhe H1 nur für das erste Abstandselement 7 dargestellt) ist kleiner als der erste Abstand A1 von dem Trägerelement 2 zu dem elektrisch isolierenden Element 5. Die jeweiligen Höhenwerten der ersten Höhe H1 der beiden Abstandselemente 7, 24 sind mit Bezug zu dem Abstandswert des ersten Abstands A1 durch die jeweiligen Ausbuchtungen 17 entsprechend reduziert.

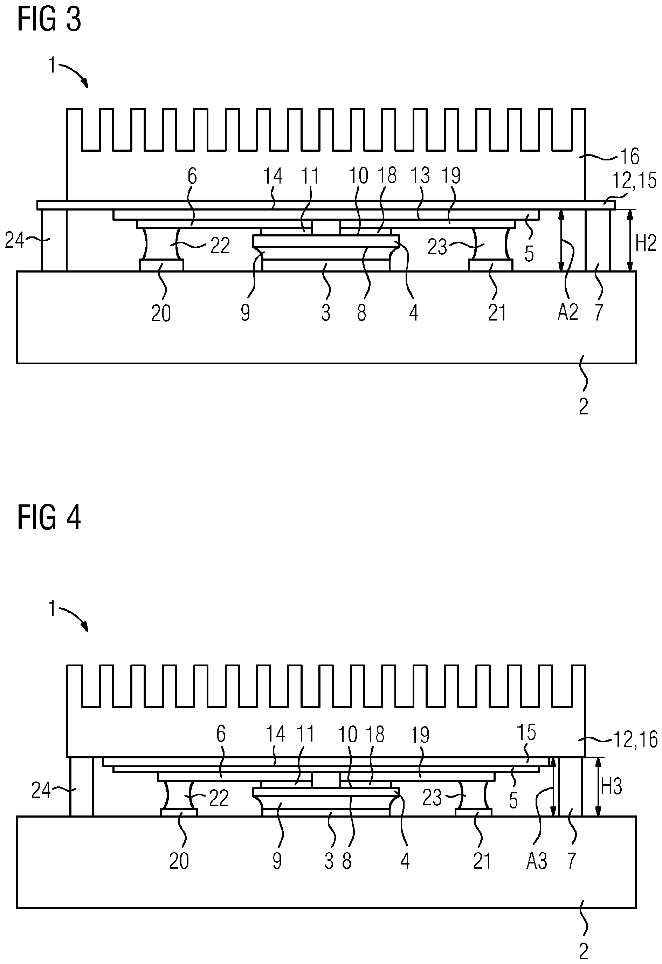

Die FIG 3 zeigt eine zweite schematische Darstellung eines Ausführungsbeispiels der erfindungsgemäßen Halbleiterbaugruppe 1 nach FIG 1 mit einem ersten Abstandselement 7 und einem weiteren Abstandselement 24, welche jeweils zwischen dem Trägerelement 2 und dem Baugruppenelement 12 angeordnet und mechanisch mit dem Trägerelement 2 und dem Baugruppenelement 12 verbunden sind, wobei das Baugruppenelement 12 als Wärmeleitelement 15 ausgebildet ist.

An einer ersten Trägerelement-Leiterbahn 3 des Trägerelements 2 ist ein Halbleiter 4 mit seiner ersten Halbleiterseite 8, welche dem Trägerelement 2 zugewandt ist, über ein erstes Verbindungsmaterial 9 elektrisch und mechanisch verbunden.

Der Halbleiter 4 ist weiterhin mit seiner zweiten Halbleiterseite 10 einerseits über ein zweites Verbindungsmaterial 11 mit einer ersten Isolationselement-Leiterbahn 6 des elektrisch isolierenden Elements 5 und andererseits über ein drittes Verbindungsmaterial 18 mit einer zweiten Isolationselement-Leiterbahn 19 des elektrisch isolierenden Elements 5 mit dem elektrisch isolierenden Element 5 an dessen erster Isolationselementseite 13 mechanisch und elektrisch verbunden.

Ferner ist die erste Isolationselement-Leiterbahn 6 über ein viertes Verbindungsmaterial 22 mit einer zweiten Trägerelement-Leiterbahn 20 des Trägerelements 2 und die zweite Isolationselement-Leiterbahn 19 über ein fünftes Verbindungsmaterial 23 mit einer dritten Trägerelement-Leiterbahn 21 des Trägerelements 2 elektrisch und mechanisch verbunden.

An der zweiten Isolationselementseite 14 des elektrisch isolierenden Elements 5 ist ein Wärmeleitelement 15 angeordnet. Über dieses Wärmeleitelement 15 ist ein Kühlkörper 16 mit dem elektrisch isolierenden Element 5 mechanisch und thermisch verbunden.

Zum Halten eines zweiten Abstands A2 von dem Trägerelement 2 zu dem Wärmeleitelement 15 (dem Baugruppenelement 12) und zum Fixieren derselben sind zwischen dem Trägerelement 2 und dem Wärmeleitelement 15 das erste Abstandselement 7 und das weitere Abstandselement 24 angeordnet und jeweils mechanisch mit dem Wärmeleitelement 15 und dem Trägerelement 2 verbunden.

Eine jeweils zweite Höhe H2 der beiden Abstandselemente 7, 24 (in FIG 3 ist die zweite Höhe H2 nur für das erste Abstandselement 7 dargestellt) ist gleich dem zweiten Abstand A2 von dem Trägerelement 2 zu dem Wärmeleitelement 15.

Eine dritte schematische Darstellung eines Ausführungsbeispiels der erfindungsgemäßen Halbleiterbaugruppe 1 nach FIG 1 mit einem ersten Abstandselement 7 und einem weiteren Abstandselement 24, welche jeweils zwischen dem Trägerelement 2 und dem Baugruppenelement 12 angeordnet und mechanisch mit dem Trägerelement 2 und dem Baugruppenelement 12 verbunden sind, wird in der FIG 4 aufgezeigt, wobei das Baugruppenelement 12 als Kühlkörper 16 ausgebildet ist.

An einer ersten Trägerelement-Leiterbahn 3 des Trägerelements 2 ist ein Halbleiter 4 mit seiner ersten Halbleiterseite 8, welche dem Trägerelement 2 zugewandt ist, über ein erstes Verbindungsmaterial 9 elektrisch und mechanisch verbunden.

Der Halbleiter 4 ist weiterhin mit seiner zweiten Halbleiterseite 10 einerseits über ein zweites Verbindungsmaterial 11 mit einer ersten Isolationselement-Leiterbahn 6 des elektrisch isolierenden Elements 5 und andererseits über ein drittes Verbindungsmaterial 18 mit einer zweiten Isolationselement-Leiterbahn 19 des elektrisch isolierenden Elements 5 mit dem elektrisch isolierenden Element 5 an dessen erster Isolationselementseite 13 mechanisch und elektrisch verbunden.

Ferner ist die erste Isolationselement-Leiterbahn 6 über ein viertes Verbindungsmaterial 22 mit einer zweiten Trägerelement-Leiterbahn 20 des Trägerelements 2 und die zweite Isolationselement-Leiterbahn 19 über ein fünftes Verbindungsmaterial 23 mit einer dritten Trägerelement-Leiterbahn 21 des Trägerelements 2 elektrisch und mechanisch verbunden.

An der zweiten Isolationselementseite 14 des elektrisch isolierenden Elements 5 ist ein Wärmeleitelement 15 angeordnet. Über dieses Wärmeleitelement 15 ist ein Kühlkörper 16 mit dem elektrisch isolierenden Element 5 mechanisch und thermisch verbunden.

Zum Halten eines dritten Abstands A3 von dem Trägerelement 2 zu dem Kühlkörper 16 (dem Baugruppenelement 12) und zum Fixieren derselben sind zwischen dem Trägerelement 2 und dem Kühlkörper 16 das erste Abstandselement 7 und das weitere Abstandselement 24 angeordnet und jeweils mechanisch mit dem Kühlkörper 16 und dem Trägerelement 2 verbunden.

Eine jeweils dritte Höhe H3 der beiden Abstandselemente 7, 24 (in FIG 4 ist die dritte Höhe H3 nur für das erste Abstandselement 7 dargestellt) ist gleich dem dritten Abstand A3 von dem Trägerelement 2 zu dem Kühlkörper 16.

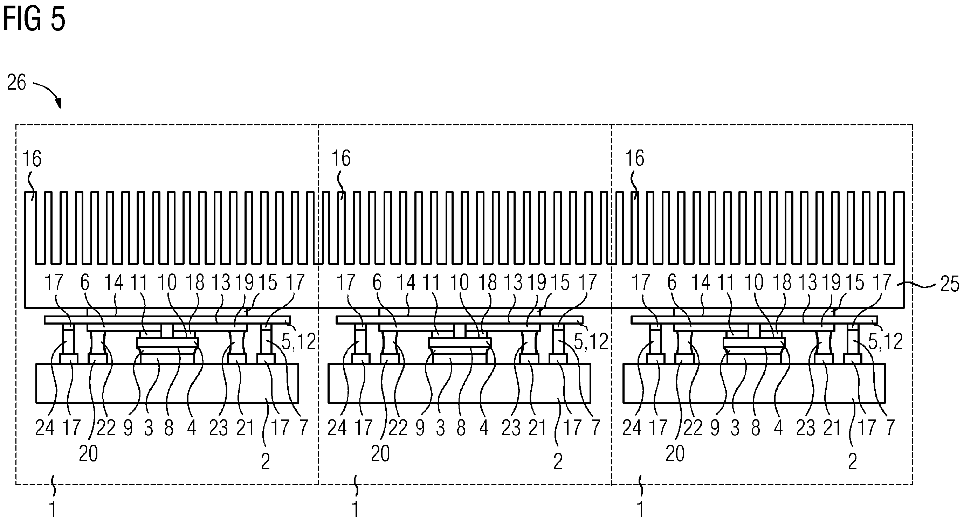

Die FIG 5 zeigt eine vierte schematische Darstellung dreier erfindungsgemäßer Halbleiterbaugruppen 1 nach FIG 1, welche gemeinsam ein Halbleiterbaugruppensystem 26 bilden.

Die hier in FIG 5 dargestellten drei Halbleiterbaugruppen 1 entsprechen jeweils der Halbleiterbaugruppe 1, wie sie mit der FIG 2 aufgezeigt wurde.

Dabei sind hier die drei Halbleiterbaugruppen 1 des Halbleiterbaugruppensystems 26 unmittelbar nebeneinander angeordnet, derart, dass durch ihre jeweiligen Kühlkörper 16 ein monolithisch aufgebauter gemeinsamer Kühlkörper 25 ausgebildet wird. Der gemeinsame Kühlkörper 25 kann jedoch auch durch die einzelnen Kühlkörper 16 der Halbleiterbaugruppe 1 in Form von Teilkühlkörpern zusammengesetzt werden.

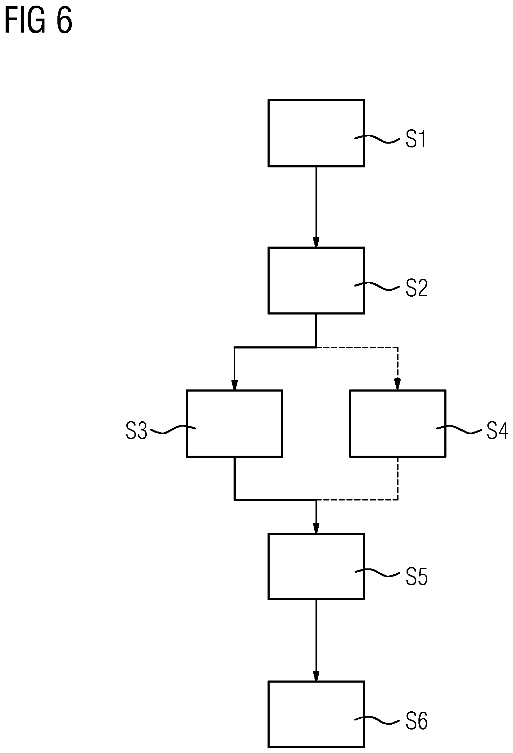

Anhand der FIG 6 wird ein Struktogramm mit einem Verfahren zur Herstellung der erfindungsgemäßen Halbleiterbaugruppe 1 nach einer der FIGen 2 bis 4 visualisiert.

Das Verfahren zur Herstellung einer erfindungsgemäßen Halbleiterbaugruppe 1 umfasst dabei die folgenden Verfahrensschritte.

In einem ersten Schritt S1 erfolgt ein formschlüssiges oder kraftschlüssiges oder stoffschlüssiges Anbringen eines ersten Abstandselements und, falls vorhanden, eines weiteren Abstandselements an ein Trägerelement und/oder ein Baugruppenelement der Halbleiterbaugruppe.

Dabei ist es hilfreich, die Abstandelemente zu fixieren, was beispielsweise mittels eines Fixierklebers erfolgen kann.

In einem zweiten Schritt S2 erfolgt ein Aufbringen eines ersten Verbindungsmaterials auf eine erste Halbleiterseite eines Halbleiters und/oder auf eine erste Trägerelement-Leiterbahn eines Trägerelements der Halbleiterbaugruppe.

Das Verbindungsmaterial kann z.B. ein Lot wie Lötzinn sein, welches als Lotdepot an der ersten Halbleiterseite des Halbleiters und/oder auf die erste Trägerelement-Leiterbahn des Trägerelements der Halbleiterbaugruppe angelegt wird.

In einem dritten Schritt S3 erfolgt ein Aufbringen eines vierten Verbindungsmaterials auf eine erste Isolationselement-Leiterbahn eines elektrischen isolierenden Elements und/oder auf eine zweite Trägerelement-Leiterbahn des Trägerelements der Halbleiterbaugruppe.

In einen vierten Schritt S4 erfolgt ein Aufbringen eines fünften Verbindungsmaterials auf eine zweite Isolationselement-Leiterbahn des elektrisch isolierenden Elements und/oder auf eine dritte Trägerelement-Leiterbahn des Trägerelements, falls eine weitere elektrische und mechanische Verbindung zwischen der zweiten Isolationselement-Leiterbahn und der dritten Trägerelement-Leiterbahn der Halbleiterbaugruppe vorgesehen ist.

Für den dritten Schritt S3 wie auch für den vierten Schritt S4 kann das Verbindungsmaterial ebenso z.B. ein Lot wie Lötzinn sein, welches als Lotdepot an den entsprechenden Leiterbahnen des Trägerelements und/oder den entsprechenden Leiterbahnen des elektrisch isolierenden Elements angelegt wird.

In einem fünften Schritt S5 erfolgt ein Anbringen des Trägerelements und des Baugruppenelements an das erste Abstandselement und, falls vorhanden, an das weitere Abstandselement.

Das Baugruppenelement kann dazu als elektrisch isolierendes Element, als Wärmeleitelement aber auch als Kühlkörper ausgebildet sein.

In einem sechsten Schritt S6 erfolgt eine thermische Behandlung des ersten Verbindungsmaterials, des vierten Verbindungsmaterials und, falls vorgesehen, des fünften Verbindungsmaterials zur Herstellung stoffschlüssiger elektrischer und mechanischer Verbindungen an den Trägerelement-Leiterbahnen, den Isolationselement-Leiterbahnen und dem Halbleiter.

Die thermische Behandlung kann vorzugsweise durch einen Lötprozess erfolgen, denkbar ist aber auch die thermische Behandlung mittels eines Sinterprozesses.

## Patentansprüche

1. Halbleiterbaugruppe (1), umfassend
- ein Trägerelement (2) mit einer ersten Trägerelement-Leiterbahn (3),
- einen Halbleiter (4),
- ein elektrisch isolierendes Element (5), aufweisend eine erste Isolationselement-Leiterbahn (6),
- ein erstes Abstandselement (7) und
- mindestens ein weiteres Abstandselement (24),
wobei
- der Halbleiter (4) an einer ersten Halbleiterseite (8) mittels eines ersten Verbindungsmaterials (9) mit der ersten Trägerelement-Leiterbahn (3) elektrisch und mechanisch verbunden ist,
- der Halbleiter (4) an einer zweiten Halbleiterseite (10), welche von der ersten Halbleiterseite (8) des Halbleiters (4) abgewandt ist, mittels eines zweiten Verbindungsmaterials (11) mit der ersten Isolationselement-Leiterbahn (6), welche an einer ersten Isolationselementseite (13) des elektrisch isolierenden Elements (5) angeordnet ist, elektrisch und mechanisch verbunden ist,
- das erste Abstandselement (7) zum Halten eines Abstands zwischen dem Trägerelement (2) und einem der zweiten Halbleiterseite (10) des Halbleiters (4) zugewandten Baugruppenelement (12) angeordnet und jeweils mit dem Trägerelement (2) und dem Baugruppenelement (12) mechanisch verbunden ist,
- das weitere Abstandselement (24) ebenfalls zum Halten des Abstands zwischen dem Trägerelement (2) und dem der zweiten Halbleiterseite (10) des Halbleiters (4) zugewandten Baugruppenelement (12) angeordnet und mechanisch mit dem Trägerelement (2) und dem Baugruppenelement (12) verbunden ist,
- das erste Abstandselement (7) und das weitere Abstandselement (24) als ein gemeinsames Abstandselement ausgebildet sind, **dadurch gekennzeichnet, dass**
- das gemeinsame Abstandselement aus zumindest zwei Segmenten besteht und einen geschlossenen oder zumindest annähernd geschlossenen Rahmen bildet.

2. Halbleiterbaugruppe (1) nach Anspruch 1, wobei das erste Abstandselement (7) und das weitere Abstandselement (24) im betriebsführenden Zustand der Halbleiterbaugruppe (1) zumindest elektrisch stromlos oder elektrisch spannungsfrei und elektrisch stromlos sind.

3. Halbleiterbaugruppe (1) nach einem der vorhergehenden Ansprüche, wobei das erste Abstandselement (7) und das weitere Abstandselement (24) jeweils einteilig oder mehrteilig, insbesondere schichtartig, ausgebildet sind.

4. Halbleiterbaugruppe (1) nach einem der vorhergehenden Ansprüche, wobei das Baugruppenelement (12)
- das elektrisch isolierende Element (5) ist oder
- ein Wärmeleitelement (15) ist, welches an einer von der ersten Isolationselementseite (13) abgewandten zweiten Isolationselementseite (14) des elektrisch isolierenden Elements (5) angeordnet und mit dem elektrisch isolierenden Element (5) mechanisch verbunden ist oder
- ein Kühlkörper (16) ist, welcher an einer von der ersten Isolationselementseite (13) abgewandten zweiten Isolationselementseite (14) des elektrisch isolierenden Elements (5) angeordnet und mit dem elektrisch isolierenden Element (5) unmittelbar oder über ein Wärmeleitelement (15) mechanisch verbunden ist.

5. Halbleiterbaugruppe (1) nach Anspruch 4, wobei dann, wenn das Baugruppenelement (12) das elektrisch isolierende Element (5) ist, das erste Abstandselement (7) und das weitere Abstandselement (24) jeweils eine erste Höhe (H1) aufweisen, deren Höhenwert maximal den Abstandswert eines ersten Abstands (A1) zwischen dem elektrisch isolierenden Element (5) und dem Trägerelement (2) im unmittelbaren Bereich der mechanischen Verbindung des jeweiligen Abstandselements (7,24) mit dem elektrisch isolierenden Element (5) und dem Trägerelement (2) annehmen kann.

6. Halbleiterbaugruppe (1) nach Anspruch 4, wobei dann, wenn das Baugruppenelement (12) das Wärmeleitelement (15) ist, das Abstandselement (7) und das weitere Abstandselement (24) jeweils eine zweite Höhe (H2) aufweisen, deren Höhenwert maximal den Abstandswert eines zweiten Abstands (A2) zwischen dem Wärmeleitelement (15) und dem Trägerelement (2) im unmittelbaren Bereich der mechanischen Verbindung des jeweiligen Abstandselements (7,24) mit dem Wärmeleitelement (15) und dem Trägerelement (2) annehmen kann.

7. Halbleiterbaugruppe (1) nach Anspruch 4, wobei dann, wenn das Baugruppenelement (12) der Kühlkörper (16) ist, das Abstandselement (7) und das weitere Abstandselement (24) jeweils eine dritte Höhe (H3) aufweisen, deren Höhenwert maximal den Abstandswert eines dritten Abstands (A3) zwischen dem Kühlkörper (16) und dem Trägerelement (2) im unmittelbaren Bereich der mechanischen Verbindung des jeweiligen Abstandselements (7,24) mit dem Kühlkörper (16) und dem Trägerelement (2) annehmen kann.

8. Halbleiterbaugruppe (1) nach einem der Ansprüche 5 bis 7, wobei an einer oder an beiden der sich gegenüberliegenden Seiten des Trägerelements (2) und des Baugruppenelements (12) Ausbuchtungen (17) vorgesehen sind, welche den jeweils ersten Abstand (A1) oder den jeweils zweiten Abstand (A2) oder den jeweils dritten Abstand (A3) an der Stelle zwischen dem Trägerelement (2) und dem Baugruppenelement (12) reduzieren, an dem das erste Abstandselement (7) und das weitere Abstandselement (24) angeordnet sind.

9. Halbleiterbaugruppe (1) nach einem der vorhergehenden Ansprüche, wobei die erste Isolationselement-Leiterbahn (6) mittels eines vierten Verbindungsmaterials (22) mit einer zweiten Trägerelement-Leiterbahn (20) elektrisch und mechanisch verbunden ist.

10. Halbleiterbaugruppe (1) nach einem der vorhergehenden Ansprüche, wobei der Halbleiter (4) an der zweiten Halbleiterseite (10) mittels eines dritten Verbindungsmaterials (18) mit einer zweiten Isolationselement-Leiterbahn (19), welche an der ersten Isolationselementseite (13) des elektrisch isolierenden Elements (5) angeordnet ist, elektrisch und mechanisch verbunden ist und wobei die zweite Isolationselement-Leiterbahn (19) mittels eines fünften Verbindungsmaterials (23) mit einer dritten Trägerelement-Leiterbahn (21) elektrisch und mechanisch verbunden ist.

11. Halbleiterbaugruppe (1) nach einem der vorhergehenden Ansprüche, wobei der Aufschmelzpunkt des ersten Abstandselements (7) und der Aufschmelzpunkt des weiteren Abstandselements (24) höher sind, als der Aufschmelzpunkt der, soweit im Einzelnen vorhanden, jeweiligen Verbindungsmaterialien (9,11,18,22,23).

12. Verfahren zur Herstellung einer Halbleiterbaugruppe (1) nach einem der Ansprüche 1 bis 11, aufweisend die folgenden Verfahrensschritte:
- einen ersten Schritt (S1) mit formschlüssigem oder kraftschlüssigem oder stoffschlüssigem Anbringen eines ersten Abstandselements (7) und eines weiteren Abstandselements (24) an ein Trägerelement (2) und/oder ein Baugruppenelement (12) der Halbleiterbaugruppe (1),
- einen zweiten Schritt (S2) mit Aufbringen eines ersten Verbindungsmaterials (9) auf eine erste Halbleiterseite (8) eines Halbleiters (4) und/oder auf eine erste Trägerelement-Leiterbahn (3) eines Trägerelements (2) der Halbleiterbaugruppe (1),
- einen dritten Schritt (S3) mit Aufbringen eines vierten Verbindungsmaterials (22) auf eine erste Isolationselement-Leiterbahn (6) eines elektrischen isolierenden Elements (5) und/oder auf eine zweite Trägerelement-Leiterbahn (20) des Trägerelements (2) der Halbleiterbaugruppe (1),
- einen vierten Schritt (S4) mit Aufbringen eines fünften Verbindungsmaterials (23) auf eine zweite Isolationselement-Leiterbahn (19) des elektrisch isolierenden Elements (5) und/oder auf eine dritte Trägerelement-Leiterbahn (21) des Trägerelements (2), falls eine weitere elektrische und mechanische Verbindung zwischen der zweiten Isolationselement-Leiterbahn (19) und der dritten Trägerelement-Leiterbahn (21) der Halbleiterbaugruppe (1) vorgesehen ist,
- einen fünften Schritt (S5) mit Anbringen des Trägerelements (2) und des Baugruppenelements (12) an das erste Abstandselement (7) und an das weitere Abstandselement (24) und
- einen sechsten Schritt (S6) mit thermischer Behandlung des ersten Verbindungsmaterials (9), des vierten Verbindungsmaterials (22) und, soweit vorhanden, des fünften Verbindungsmaterials (23) zur Herstellung stoffschlüssiger elektrischer und mechanischer Verbindungen an den Trägerelement-Leiterbahnen (3,20,21), den Isolationselement-Leiterbahnen (6, 19) und dem Halbleiter (4).

13. Halbleiterbaugruppensystem (26) mit mindestens zwei Halbleiterbaugruppen (1) nach einem der Ansprüche 1 bis 11, wobei die jeweiligen Kühlkörper (16) der mindestens zwei Halbleiterbaugruppen (1) einen gemeinsamen Kühlkörper (25) ausbilden.

## Claims

1. Semiconductor assembly (1), comprising
- a carrier element (2) with a first carrier element conductor path (3),
- a semiconductor (4),
- an electrically insulating element (5), having a first insulating element conductor path (6),
- a first spacer element (7) and
- at least one further spacer element (24),
wherein
- the semiconductor (4) is connected electrically and mechanically on a first semiconductor side (8) by means of a first connecting material (9) to the first carrier element conductor path (3),
- the semiconductor (4) is connected electrically and mechanically on a second semiconductor side (10), which faces away from the first semiconductor side (8) of the semiconductor (4), by means of a second connecting material (11) to the first insulating element conductor path (6), which is arranged on a first insulating element side (13) of the electrically insulating element (5),
- the first spacer element (7) is arranged for maintaining a distance between the carrier element (2) and an assembly element (12) which faces towards the second semiconductor side (10) of the semiconductor (4), and is connected mechanically to the carrier element (2) and the assembly element (12) respectively,
- the further spacer element (24) is also arranged for maintaining the distance between the carrier element (2) and the assembly element (12) which faces towards the second semiconductor side (10) of the semiconductor (4), and is connected mechanically to the carrier element (2) and the assembly element (12) respectively,
- the first spacer element (7) and the further spacer element (24) are embodied as a common spacer element, **characterised in that**
- the common spacer element comprises at least two segments and forms a closed or at least almost closed frame.

2. Semiconductor assembly (1) according to claim 1, wherein the first spacer element (7) and the further spacer element (24) are at least electrically currentless or electrically volt-free and electrically currentless when the semiconductor assembly (1) is operational.

3. Semiconductor assembly (1) according to one of the preceding claims, wherein the first spacer element (7) and the further spacer element (24) are each embodied in one piece or in several pieces, in particular in a layered manner.

4. Semiconductor assembly (1) according to one of the preceding claims, wherein the assembly element (12)
- is the electrically insulating element (5) or
- is a heat conducting element (15), which is arranged on a second insulating element side (14) facing away from the first insulating element side (13) of the electrically insulating element (5) and is connected mechanically to the electrically insulating element (5) or
- is a heat sink (16), which is arranged on a second insulating element side (14) facing away from the first insulating element side (13) of the electrically insulating element (5) and is connected mechanically to the electrically insulating element (5), either directly or by way of a heat conducting element (15).

5. Semiconductor assembly (1) according to claim 4, wherein, if the assembly element (12) is the electrically insulating element (5), the first spacer element (7) and the further spacer element (24) each have a first height (H1), the height value of which can assume as a maximum the distance value of a first distance (A1) between the electrically insulating element (5) and the carrier element (2) in the direct region of the mechanical connection of the respective spacer element (7, 24) to the electrically insulating element (5) and the carrier element (2).

6. Semiconductor assembly (1) according to claim 4, wherein, if the assembly element (12) is the heat conducting element (15), the spacer element (7) and the further spacer element (24) each have a second height (H2), the height value of which can assume as a maximum the distance value of a second distance (A2) between the heat conducting element (15) and the carrier element (2) in the direct region of the mechanical connection of the respective spacer element (7, 24) to the heat conducting element (15) and the carrier element (2).

7. Semiconductor assembly (1) according to claim 4, wherein, if the assembly element (12) is the heat sink (16), the spacer element (7) and the further spacer element (24) each have a third height (H3), the height value of which can assume as a maximum the distance value of a third distance (A3) between the heat sink (16) and the carrier element (2) in the direct region of the mechanical connection of the respective spacer element (7, 24) to the heat sink (16) and the carrier element (2) .

8. Semiconductor assembly (1) according to one of claims 5 to 7, wherein protrusions (17) are provided on one or on both opposing sides of the carrier element (2) and the assembly element (12), which protrusions reduce the respectively first distance (A1) or the respectively second distance (A2) or the respectively third distance (A3) at the point between the carrier element (2) and the assembly element (12) at which the first spacer element (7) and the further spacer element (24) are arranged.

9. Semiconductor assembly (1) according to one of the preceding claims, wherein the first insulating element conductor path (6) is connected electrically and mechanically to a second carrier element conductor path (20) by means of a fourth connecting material (22).

10. Semiconductor assembly (1) according to one of the preceding claims, wherein the semiconductor (4) is connected electrically and mechanically on the second semiconductor side (10) by means of a third connecting material (18) to a second insulating element conductor path (19) which is arranged on the first insulating element side (13) of the electrically insulating element (5), and wherein the second insulating element conductor path (19) is connected electrically and mechanically by means of a fifth connecting material (23) to a third carrier element conductor path (21).

11. Semiconductor assembly (1) according to one of the preceding claims, wherein the melting point of the first spacer element (7) and the melting point of the further spacer element (24) are higher than the melting point of the respective connecting materials (9,11,18,22,23) insofar as these are present individually.

12. Method for producing a semiconductor assembly (1) according to one of claims 1 to 11, having the following method steps:
- a first step (S1) involving the application of a first spacer element (7) and a further spacer element (24) in a form-fit or force-fit or material-bonded manner to a carrier element (2) and/or an assembly element (12) of the semiconductor assembly (1),
- a second step (S2) involving the application of a first connecting material (9) to a first semiconductor side (8) of a semiconductor (4) and/or to a first carrier element conductor path (3) of a carrier element (2) of the semiconductor assembly (1),
- a third step (S3) involving the application of a fourth connecting material (22) to a first insulating element conductor path (6) of an electrically insulating element (5) and/or to a second carrier element conductor path (20) of the carrier element (2) of the semiconductor assembly (1),
- a fourth step (S4) involving the application of a fifth connecting material (23) to a second insulating element conductor path (19) of the electrically insulating element (5) and/or to a third carrier element conductor path (21) of the carrier element (2), if provision is made for a further electrical and mechanical connection between the second insulating element conductor path (19) and the third carrier element conductor path (21) of the semiconductor assembly (1),
- a fifth step (S5) involving the application of the carrier element (2) and the assembly element (12) to the first spacer element (7) and to the further spacer element (24), and
- a sixth step (S6) involving a thermal treatment of the first connecting material (9), the fourth connecting material (22) and, if present, the fifth connecting material (23) in order to produce material-bonded electrical and mechanical connections to the carrier element conductor paths (3,20,21), the insulating element conductor paths (6,19) and the semiconductor (4).

13. Semiconductor assembly system (26) with at least two semiconductor assemblies (1) according to one of claims 1 to 11, wherein the respective heat sinks (16) of the at least two semiconductor assemblies (1) embody a common heat sink (25).

## Revendications

1. Module (1) à semi-conducteur, comprenant :
- un élément (2) support ayant une première piste (3) conductrice d'élément support,
- un semi-conducteur (4),
- un élément (5) isolant électriquement, ayant une première piste (6) conductrice d'élément isolant,
- un premier élément (7) d'entretoisement et
- au moins un autre élément (24) d'entretoisement,
dans lequel
- le semi-conducteur (4) est, sur une première face (8) du semi-conducteur au moyen d'un premier matériau (9) de liaison, relié électriquement et mécaniquement à la première piste (3) conductrice de l'élément support,
- le semi-conducteur (4) est, sur une deuxième face (10) du semi-conducteur, qui est loin de la première face (8) du semi-conducteur (4) au moyen d'un deuxième matériau (11) de liaison, relié électriquement et mécaniquement à la première piste (6) conductrice de l'élément isolant, qui est disposée sur une première face (13) de l'élément (5) isolant électriquement,
- le premier élément (7) d'entretoisement est disposé de manière à maintenir une distance entre l'élément (2) et un élément (12) du module tourné vers la deuxième face (10) du semi-conducteur (4) et relié mécaniquement respectivement à l'élément (2) support et à l'élément (12) de module,
- l'autre élément (24) d'entretoisement est disposé également de manière à maintenir la distance entre l'élément (2) de support et l'élément (12) du module tourné vers la deuxième face (10) du semi-conducteur (4) et est relié mécaniquement à l'élément (2) de support et à l'élément (12) du module,
- le premier élément (7) d'entretoisement et l'autre élément (24) d'entretoisement sont constitués sous la forme d'un élément d'entretoisement commun,
**caractérisé en ce que**
- l'élément d'entretoisement commun est constitué d'au moins deux segments et forme un cadre fermé ou au moins à peu près fermé.

2. Module (1) à semi-conducteur suivant la revendication 1, dans lequel le premier élément (7) d'entretoisement et l'autre élément (24) d'entretoisement sont dans l'état d'exploitation du module (1) à semi-conducteur au moins électriquement sans courant ou électriquement sans tension et électriquement sans courant.

3. Module (1) à semi-conducteur suivant l'une des revendications précédentes, dans lequel le premier élément (7) d'entretoisement et l'autre élément (24) d'entretoisement sont constitués chacun en une pièce ou en plusieurs pièces, notamment en étant stratifiés.

4. Module (1) à semi-conducteur suivant l'une des revendications précédentes, dans lequel l'élément (12) du module
- est l'élément (5) isolant électriquement ou
- un élément (15) conducteur de la chaleur, qui est disposé sur une deuxième face (14), loin de la première face (13), de l'élément (5) isolant électriquement et qui est relié mécaniquement à l'élément (5) isolant électriquement ou
- est un puits (16) de chaleur, qui est disposé sur une deuxième face (14) isolante, loin de la première face (13) isolante, de l'élément (5) isolant électriquement et qui est relié mécaniquement à l'élément (5) isolant électriquement directement ou par un élément (15) conducteur de la chaleur.

5. Module (1) à semi-conducteur suivant la revendication 4, dans lequel, lorsque l'élément (12) du module est l'élément (5) isolant électriquement, le premier élément (7) d'entretoisement et l'autre élément (24) d'entretoisement ont chacun une première hauteur (H1), dont la valeur peut prendre au maximum la valeur d'une première distance (A1) entre l'élément (5) isolant électriquement et l'élément (2) support dans la partie immédiate de la liaison mécanique de l'élément (7, 24) d'entretoisement respectif avec l'élément (5) isolant électriquement et l'élément (2) support.

6. Module (1) à semi-conducteur suivant la revendication 4, dans lequel, lorsque l'élément (12) du module est l'élément (15) conducteur de la chaleur, l'élément (7) d'entretoisement et l'autre élément (24) d'entretoisement ont chacun une deuxième hauteur (H2), dont la valeur peut prendre au maximum la valeur d'une deuxième distance (A2) entre l'élément (15) conducteur de la chaleur et l'élément (2) support dans la partie immédiate de la liaison mécanique de l'élément (7, 24) d'entretoisement respectif avec l'élément (15) conducteur de la chaleur et l'élément (2) support.

7. Module (1) à semi-conducteur suivant la revendication 4, dans lequel, lorsque l'élément (12) de module est le puits (16) de chaleur, l'élément (7) d'entretoisement et l'autre élément (24) d'entretoisement ont chacun une troisième hauteur (H3), dont la valeur peut prendre au maximum la valeur d'une troisième distance (A3) entre le puits (16) de chaleur et l'élément (2) support dans la partie immédiate de la liaison mécanique de l'élément (7, 24) d'entretoisement respectif avec le puits (16) de chaleur et l'élément (2) support.

8. Module (1) à semi-conducteur suivant l'une des revendications 5 à 7, dans lequel, sur l'une ou sur deux des faces opposées de l'élément (2) support et de l'élément (12) du module sont prévues des indentations (17), qui réduisent la première distance (A1) ou la deuxième distance (A2) respective ou la troisième distance (A3) respective à l'endroit entre l'élément (2) support et l'élément (12) du module où sont disposés le premier élément (7) d'entretoisement et l'autre élément (24) d'entretoisement.

9. Module (1) à semi-conducteur suivant l'une des revendications précédentes, dans lequel la première piste (6) conductrice d'élément isolant est reliée électriquement et mécaniquement à une deuxième piste (20) conductrice d'élément support au moyen d'un quatrième matériau (22) de liaison.

10. Module (1) à semi-conducteur suivant l'une des revendications précédentes, dans lequel le semi-conducteur (4) est, sur la deuxième face (10) du semi-conducteur au moyen d'un troisième matériau (18) de liaison, relié électriquement et mécaniquement à une deuxième piste (19) conductrice de l'élément isolant, qui est disposée sur la première face (13) de l'élément (5) isolant électriquement et dans lequel la deuxième piste (19) conductrice d'élément isolant est reliée électriquement et mécaniquement à une troisième piste (21) conductrice de l'élément support au moyen d'un cinquième matériau (23) de liaison.

11. Module (1) à semi-conducteur suivant l'une des revendications précédentes, dans lequel le point de fusion du premier élément (7) d'entretoisement et le point de fusion de l'autre élément (24) d'entretoisement sont plus hauts que le point de fusion des, pour autant qu'ils soient présents, matériaux (9, 11, 18, 22, 23) respectifs de liaison.

12. Procédé de fabrication d'un module (1) à semi-conducteur suivant l'une des revendications 1 à 11, comportant les stades de procédé suivants :
- un premier stade (S1) avec mise à complémentarité de forme ou à coopération de force ou à coopération de matière d'un premier élément (7) d'entretoisement et d'un autre élément (24) d'entretoisement sur un élément (2) support et/ou un élément (12) de module du module (1) à semi-conducteur,
- un deuxième stade (S2) avec dépôt d'un premier matériau (9) de liaison sur une première face (8) d'un semi-conducteur (4) et/ou sur une première piste (3) conductrice d'un élément (2) support du module (1) à semi-conducteur,
- un troisième stade (S3) avec dépôt d'un quatrième matériau (22) de liaison sur une première piste (6) conductrice d'un élément (5) isolant électriquement et/ou sur une deuxième piste (20) de l'élément (2) support du module (1) à semi-conducteur,
- un quatrième stade (S4) avec dépôt d'un cinquième matériau (23) de liaison sur une deuxième piste (19) conductrice de l'élément (5) isolant électriquement et/ou sur une troisième piste (21) conductrice de l'élément (2) support, s'il est prévu une autre liaison électrique et mécanique entre la deuxième piste (19) conductrice d'élément isolant et la troisième piste (21) conductrice d'élément support du module (1) à semi-conducteur,
- un cinquième stade (S5) avec dépôt de l'élément (2) support et de l'élément (12) du module sur le premier élément (7) d'entretoisement et sur l'autre élément (24) d'entretoisement,
- un sixième stade (S6) avec traitement thermique du premier matériau (9) de liaison, du quatrième matériau (22) de liaison et, dans la mesure où il est présent, du cinquième matériau (23) de liaison pour la production de liaisons électriques et mécaniques à coopération de matière sur les pistes (3, 20, 21) conductrices de l'élément support, les pistes (6, 19) conductrices d'élément isolant et le semi-conducteur (4).

13. Système (26) de module à semi-conducteur ayant au moins deux modules (1) à semi-conducteur suivant l'une des revendications 1 à 11, dans lequel les puits (16) de chaleur respectifs des au moins deux modules (1) à semi-conducteur constituent un puits (25) de chaleur commun.
